# EUROPÄISCHE PATENTSCHRIFT

(11) **EP 1 593 983 B1**
(45) Veröffentlichungstag und Bekanntmachung des Hinweises auf die Patenterteilung: **22.08.2012**
(21) Anmeldenummer: 05004509.5
(22) Anmeldetag: 02.03.2005
(51) Int. Cl.: G01R 31/08, H02H 1/00, H02H 3/17, H02H 5/10

(54) **Verfahren und Einrichtung zur Isolationsfehlerortung in einem isolierten, ungeerdeten Wechselstromnetz**
Method of and apparatus for locating an insulation fault in an unearthed alternating voltage network
Procédé et dispositif pour localiser les défauts d'isolation dans un réseau à tension alternatif

(30) Priorität: 19.04.2004 DE 102004018918
(43) Veröffentlichungstag der Anmeldung: 09.11.2005
(73) Patentinhaber: EAN Elektroschaltanlagen Grimma GmbH, 04668 Grimma (DE)
(72) Erfinder: Steuernagel, Thomas, Dipl.-Ing., 04683 Naunhof (DE); Rathsmann, Stephan, Dipl.-Ing., 04317 Leipzig (DE)
(74) Vertreter: Köhler, Tobias

(56) Entgegenhaltungen:
- DE-A1- 2 515 121
- US-A- 4 012 668
- US-A1- 2002 024 342

## Beschreibung

Die Erfindung betrifft ein Verfahren und eine Einrichtung zur Ortung von Isolationsfehlern in einem ungeerdeten elektrischen Wechselspannungsnetz, wobei in diesen zur Isolationsüberwachung des gesamten Netzes ein Isolationsüberwachungsgerät angeordnet ist, dass bei einem auftretenden Isolationsfehler über einen dann aktivierten Prüfspannungsgenerator ein Prüfstrom zwischen Netz und Erde erzeugt wird. Durch Anordnung von Differenzstromwandlern in jeden Netzabgang wird der durch die netzeigene Prüfspannung erzeugte Prüfstrom pro Abgang erfasst und so ausgewertet, dass bei Überschreitung eines parametrierbaren Grenzwertes der fehlerhafte Netzabgang über eine Meldung bzw. Anzeigeeinheit lokalisiert wird.

In geerdeten Netzen werden zur Ortung von Isolationsfehlern die Unsymmetriespannung und/oder der Summenstrom als Kriterium genutzt.

In der US 2002/024342 A1 ist ein Verfahren zur Positionierung und Lokalisierung von Isolationsfehlern in Kabelnetzen mit metallenem Schirm beschrieben. Dazu wird zwischen einem Einspeisepunkt und einem Endpunkt des Kabels ein Strom eingespeist. Am Einspeisepunkt und am Endpunkt des Kabels wird die zugehörige Spannung gemessen und das Verhältnis der beiden Spannungen entspricht dem Fehlerort zwischen den Punkten.

Im Gegensatz zur vorliegenden Erfindung, die sich auf isolierte ungeerdete Wechselstromnetze bezieht, wird ein Strom mit fester Frequenz und isoliert gegen Erde eingespeist und Spannungsmessungen am Kabelanfang und -ende durchgeführt, wobei das Verhältnis der Spannungen dem Verhältnis des Fehlerortes zu den Punkten des Kabels entspricht. Nachteilig ist, dass mit diesen Verfahren nur Fehler an frei geschalteten Kabeln mit Metallummantelung lokalisiert werden können und der Kabelanfang und das Kabelende für Messungen zugänglich sein muss. Isolationsfehler an Netzabgängen mit angeschlossenen Verbrauchern in Betrieb können nicht lokalisiert werden.

Aus der WO 02/15355 A2 ist ein Verfahren und eine Vorrichtung zur selektiven Erkennung und Ortung von hochohmigen einpoligen Erdfehlern bekannt, bei der ein netzfrequentes Hilfssignal über den Löschkreis eingespeist wird und dadurch die Sternpunkt-Verlagerungsspannung kompensiert wird und Erdfehler bei kompensierter Sternpunkt-Verlagerungsspannung erkannt werden.

Aus der WO 2004/003578 A1 ist ein Verfahren zur Ortung von hochohmigen Erdfehlern bekannt, wobei die Erdadmittanz bzw. Nulladmittanz eines Leitungsabschnittes bzw. - abzweiges durch Einspeisen eines Hilfsignales in den Netzsternpunkt bzw. Nullsystem mit einer Frequenz ungleich der Netzfrequenz ermittelt und zur Erkennung von Erdfehlern herangezogen wird.

In isolierten Netzen erfolgt in analoger Weise die Ortung von Erdschlüssen durch Anordnung von Überstromrelais in den Summenstromkreisen über den kapazitiven Erdschlussstrom über der Erdschlussstelle.

Derartige Verfahren und Vorrichtungen basieren auf der Ermittlung von Verlagerungsspannung, Erdschluss- bzw. Summenstrom und dem Einschwingstrom und sind nicht zur Erkennung und Lokalisierung von Isolationsfehlern in isolierten Netzen einsetzbar.

Es ist weiterhin bekannt, dass in isolierten elektrischen Netzen (IT - Netze) wie z. B. in Krankenhäusern Isolationsüberwachungsgeräte zur Überwachung des Isolationswiderstandes des gesamten Netzes angeordnet werden. Bei Unterschreitung eines minimalen Wertes des Isolationswiderstandes des gesamten Netzes wird ein Warnsignal als Meldung erzeugt. Um den fehlerhaften Abgang schnell zu lokalisieren ist bekannt, bei Ansprechen des Isolationsüberwachungsgerätes auf Grund von Isolationsfehlern einen geringen Prüfstrom fließen zu lassen und über Anordnung von empfindlichen Differenzstromwandlern in jeden Netzabgang eine Fehlerortung durchzuführen. Dabei schaltet das Isolationsüberwachungsgerät entweder netzabhängige und netzunabhängige Prüfspannungsgeneratoren ein, die im isolierten Netz einen sehr geringen und damit ungefährlichen Prüfstrom über den Isolationswiderstand und die Netzersatzkapazitäten zwischen Netz und Erde fließen lassen.

Zur Gewährleistung des Personenschutzes sind im isolierten Netz nur geringste Prüfströme bis maximal 1 mA zwischen Netz und Erde möglich, so dass bei diesem Verfahren sehr geringe Prüfströme bei sehr niedriger Frequenz von z. B. 2 Hz in den Differenzstromwandlern erfasst werden müssen. Damit werden durch die Differenzstromwandler nur tiefe Frequenzen erfasst.

Trotz der geringen Prüfstromfrequenz werden Netzstörungen z. B. durch Schaltvorgänge von Transformatoren, Schütze usw. im Netz erzeugt, die als niederfrequente Netzstörung das Messergebnis der Prüfsignale verfälschen, wodurch dieses Verfahren zur Fehlerortung in IT - Netzen sehr störempfindlich und unzuverlässig ist. Es werden durch Netzstörungen bedingt bei diesem Verfahren und Einrichtungen oft fehlerhafte Netzabgänge lokalisiert.

Der vorliegenden Erfindung liegt die Aufgabe zugrunde, ein Verfahren und eine Einrichtung der im Oberbegriff genannten Art zu schaffen, bei dem Netzstörungen in IT - Netzen erkannt und durch entsprechende Maßnahmen vor Auftreten von Isolationsfehlern bei der Fehlerortung eliminiert werden und eine schnelle und fehlerfreie Lokalisierung fehlerhafter Netzabgänge von IT - Netzen erfolgen kann.

Die Lösung der Aufgabe erfolgt dadurch, dass vor Auftreten eines Isolationsfehlers die Netzstörungen über busfähige Differenzstromwandler mit Messverstärker und Mikrorechner pro Netzabgang erfasst werden, über die zugehörige Stromzeitfläche unter Beachtung des maximal zulässigen Prüfstromes eine minimale Prüfimpulszeit ermittelt wird, die zusammen mit einer entsprechend variablen Pausenzeit als optimale Vorgabewerte an einen Prüfspannungsgenerator übermittelt werden, so dass bei Auftreten eines Isolationsfehlers Prüfimpulse zwischen Netz und Erde mit einer optimalen Prüfimpulszeit und Pausenzeit gebildet werden, die gleich oder größer sind als die erfassten Netzstörungen und damit schnellere Fehlerortung ermöglicht und fehlerhafte Messungen vermeidet. Durch zyklische Abfrage bei Ausbleiben von Netzstörungen wird die Prüfimpulszeit und Pausenzeit kontinuierlich bis auf einen Minimalwert von ca. 2 Sekunden verringert. Außerdem wird durch Auswahl der Prüfspannungsform und Prüfspannungsfolge eine Zuordnung des Isolationsfehlerortes pro Leitung bzw. bei vorhandenen elektronischen Geräten die Unterscheidung bezüglich Geräte- oder Leitungsfehler ermöglicht.

Eine geeignete Vorrichtung zur Umsetzung des Verfahrens wird durch einen Prüfspannungsgenerator mit Mikrorechner, Strombegrenzung und einzeln schaltbaren Gleichrichterdioden einer Brückenschaltung zur Prüfsignalerzeugung gebildet. Der Mikrorechner übernimmt alle Funktionen der Steuerung des Prüfspannungsgenerators.

Außerdem sind Differenzstromwandler in jeden Netzabgang angeordnet, die mit Messverstärker, Analog Digital Wandler, Mikrorechner und schaltbarer Rückkopplung im Messkreis zur Kompensation des ohmschen Widerstandes des Differenzstromwandlers während der Prüfimpulszeit und zur Nullstellung des Messstromes in der Pausenzeit ein Messsignal über eine große Prüfimpulszeit bis zu 20 Sekunden und Datenbusverbindung mit allen Geräten erreicht.

Nachfolgend ist das erfindungsgemäße Verfahren beispielhaft beschrieben:
Zur Lösung der gestellten Aufgabe eignet sich ein Verfahren der im Oberbegriff von Anspruch 1 genannten Art dadurch, dass bei Auftreten eines Isolationsfehlers im Netz ein Prüfimpulswechselstrom zwischen Netz und Erde aus mehreren netzsynchronen Einzelimpulsen unmittelbar aus der Netzspannung mit variabler Zykluszeit erzeugt wird und die Prüfimpulszeit vor Auftreten eines Isolationsfehlers in Abhängigkeit von den aufgetretenen elektrischen Störungen pro Netzabgang ermittelt und die Stromzeitfläche aus Prüfstrom und Prüfimpulszeit gleich oder größer als die Stromzeitfläche der letzten Netzstörungen ist.
Dazu werden die elektrischen Störungen pro Netzabgang laufend erfasst und die Stromzeitfläche von Netzstörungen pro Netzabgang ermittelt und unter Berücksichtigung des maximal möglichen Prüfstromes von z. B. 1 mA in IT - Netzen für Krankenhäuser die Prüfimpulszeit berechnet, so dass damit die Prüfimpulszeit immer größer ist als die in einer bestimmten Zeit aufgetretenen Stromzeitfläche der Netzstörungen. Bei Ausbleiben von weiteren Netzstörungen erfolgt eine schrittweise Verringerung der Prüfimpulszeit bis minimal ca. 2 Sekunden,
dass aus Prüfimpulswechselströmen über Differenzstromwandler Messströme pro Netzabgang mit einer Prüfimpulszeit bis ca. 20 Sekunden gebildet werden,
dass vor Auftreten eines Isolationsfehlers die Netzstörungen pro Netzabgang durch vektorielle Erfassung der jeweiligen Betriebsströme der Betriebsleiter erfasst werden,
dass die Prüfspannungsform und Prüfimpulszeit verschieden und variabel ist,
dass bei Auftreten eines Isolationsfehlers für jeden Netzabgang der Prüfstrom zeitgleich erfasst wird und aus mindestens zwei Messwerten durch Vergleich auch Netzstörungen während der Zykluszeit erkannt werden,
dass bei Auftreten eines Isolationsfehlers eine Lokalisierung des fehlerhaften Abganges durch zeitgleiche Erfassung aller Netzabgänge unmittelbar erfolgt.

Eine automatische Anpassung der Prüfimpulszeit und damit der Messzeit an die vorhandenen Störverhältnisse wird wie nachstehend realisiert:
Kurzzeitig auftretende magnetische Gleichfelder, wie sie von Einschaltströmen induktiver Lasten verursacht werden, können die Messung mit dem empfindlichen Differenzstromwandlern verfälschen. Durch Wahl einer gegenüber den Störimpulsen langen Messzeit, kann das Auswertegerät die Verfälschung durch Mittelwertbildung gering halten. Durch ständige Überwachung seiner Messwerte während des normalen Netzbetriebes (ohne Isolationsfehler) passt das System seine Messzeit an die jeweiligen Störverhältnisse an. Im Fall eines Isolationsfehlers dauert die Suche nur so lang wie nötig.

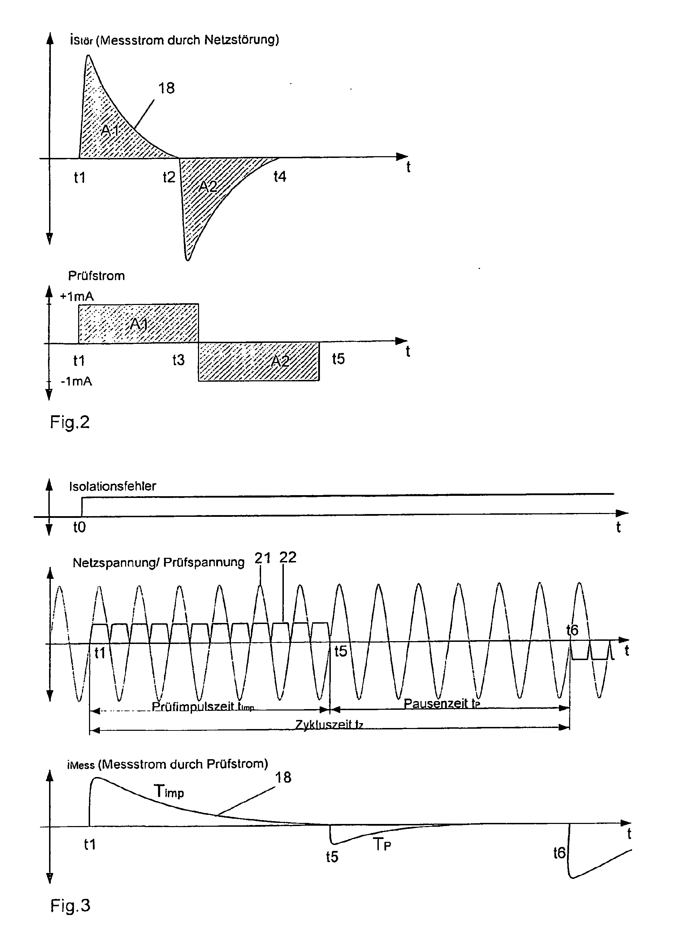

Während der Messzeit wird die negative Zeitkonstante des Messsignals durch Simulation eines negativen Widerstandes über Rückkopllung im Messkreis bestimmt und bei Beginn der Pausenzeit erfolgt eine Nullpunktstellung des Messsignals über Rückkopplung im Messkreis.
Zur Vermeidung von Störungen sind Messzeiten bis ca. 20 Sekunden erforderlich. Durch Anordnung einer veränderlichen Rückkopllung zwischen Messverstärker und Messstromkreis des Differenzstromwandlers wird der Abfall des Messsignals bis ca. 20 Sekunden verzögert.
Während der Messzeit realisiert die Rückkopplung einen negativen Widerstand im Messkreis und damit eine Vergrö-βerung der Messzeitkonstante Timp (Fig.3) .
In den Messpausen wird zwischen Messverstärker und Messkreis die Rückkopplung als PI - Regler geschaltet, wodurch das Messsignal zwangsweise auf Null TP (Fig.3)gestellt wird und damit die Messbereitschaft für den nächsten Prüfimpuls hergestellt wird.

Die Prüfspannungsimpulse können positiv oder negativ sein, eine vorhandene Differenz der beiden zugehörigen Messwerte kennzeichnet genau die fehlerhafte Leitung.

Ein solches Verfahren ist vorteilhaft in Verbindung mit einem Isolationsüberwachungsgerät als Isolationsfehlersuchsystem in verzweigten ungeerdeten Wechselstromnetzen wie zum Beispiel für Krankenhäuser einsetzbar und erlaubt eine zuverlässige, schnelle und störungsunanfällige Ortung und Überwachung fehlerhafter Netzabgänge.

Eine geeignete Einrichtung zur Realisierung des beschriebenen Verfahrens ist, dass bei vorhandenen Isolationsfehlern über einen netzgebundenen _{P}rüfspannungsgenerator ungeglättete und netzsynchrone pulsierende Ableitströme zwischen den Leitern erzeugt werden, die über Strombegrenzung auf eine ungefährliche Größe von ca. 1 mA begrenzt werden. Über elektronische Schalter in jeden Gleichrichterzweig des Prüfspannungsgenerators kann eine pulsierende Gleichspannung als Prüfspannung über eine Zweiweg- oder Einweggleichrichtung mit unterschiedlicher Form, Polarität und Frequenz erzeugt werden.

In jeden Netzabgang ist ein Differenzstromwandler 5 angeordnet. Dieser ist mit Differenzstromsensor 6, Messverstärker 9, Analog Digital Umsetzer 11, und schaltbarer Rückkopplung 10 mit Digital Analog Umsetzer 12 und Einkopplung EK zwischen Analog Digital Umsetzer 11 des Messverstärkers 9 und Differenzstromsensor 6 ausgeführt.

Bei Auftreten eines Prüfstromes auf Grund eines Isolationsfehlers und aktiven Prüfspannungsgenerator erfasst der Differenzstromwandler 5 die zeitlichen Prüfstromänderungen und über die Rückkopplung 10 und Einkopplung EK wird eine negative Spannung in den Messkreis eingekoppelt, so dass dadurch die Zeitkonstante T_{M} des Messstromes iMess automatisch verlängert wird und dadurch während der gesamten Prüfimpulszeit trotz vorhandenen Prüfstrom in Form eines pulsförmigen Gleichstromes ein Differenzstrom Messwert in Form einer e-Funktion erzeugt wird. Am Ende der Prüfimpulszeit wird der Prüfstrom Null und die schaltbare Rückkopplung 10 als PI-Regler geschaltet, so dass dadurch eine zwangsweise Nullpunktstellung des Messstromes 18 über die Zeitkonstante T_{P} erzwungen wird. Die Messströme in einem Netzabgang werden über Mikrorechner 13 digital erfasst und gespeichert. Durch den Mikrorechner 13 erfolgt während jeder Prüfspannungszeit eine Mittelwertbildung des Messstromes pro Netzabgang. Dieser Mittelwert ist ein Maß für den Isolationsfehler pro Netzabgang. Der Mikrorechner 13 übernimmt alle Steuerungen und Berechnungen. Über vorhandene Busschnittstellen des Mikrorechners 13 können alle erfolgten Auswertungen und Ergebnisse zeitgleich über alle Netzabgänge erfolgen.

Die Erfindung wird anhand der folgenden Ausführungsbeispiele näher erläutert und es zeigen:
Fig. 1 Übersichtsdarstellung einer Einrichtung nach der vorliegenden Erfindung
Fig. 2 Zeitlicher Verlauf und Darstellung Stromzeitfläche einer Netzstörung
Fig. 3 Zeitlicher Verlauf Prüfspannung und Messstrom Zunächst wird auf das bekannte Verfahren zur Isolationsfehlerortung in isolierten Netzen näher eingegangen. In Fig. 1 ist ein isoliertes Netz bestehend aus den Netzleitern 1 dargestellt. Ein unvermeidbarer Isolationswiderstand mit ohmschen Widerstand Rₑ und kapazitiven Widerständen Cₑ stellt eine Netzableitung zwischen Netzleitern 1 und Erde dar. Zur Überwachung des ohmschen Anteiles des Isolationswiderstandes ist ein Isolationsüberwachungsgerät 2 zwischen Netzleitern 1 und Erde angeordnet.

Bei Auftreten eines maßgeblichen Isolationsfehlers im Netz erfolgt die Feststellung desselben mit einem Isolationsüberwachungsgerät 2 und es erfolgt eine Meldung über ein nicht dargestelltes Auswertungsgerät.
Außerdem erfolgt eine Aktivierung eines Prüfspannungsgenerators 3 derart, dass dieser dann einen netzgetriebenen Prüfstrom fester Frequenz über die Ableitwiderstände Rₑ erzeugt und dieser für jeden Netzabgang mittels Differenzstromwandler gemessen wird und die einzelnen Differenzstrom Messwerte zeitmultiplex an eine Auswerteeinheit übertragen werden. Nach Auswertung der Messergebnisse aller Netzabgänge kann dadurch eine Isolationsfehlerortung erfolgen.

Der wesentliche Nachteil besteht darin, dass die fest vorhandene Prüfimpulszeit des Prüfspannungsgenerators an die Länge der maximal möglichen Übertragungszeit des induktiven Messverfahrens des Differenzstromwandlers angepasst sind und damit maximale Messzeiten von ca. 2 Sekunden zur Erfassung des Prüfsignals möglich sind. Netzstörungen, die z. B. auf Grund von Schalthandlungen von Transformatoren, Schützen im Netz auftreten, werden in dieser festen Messzeit mit erfasst und führen zu Messfehlern. Wenn nämlich während der Prüfimpulsdauer Netzstörungen auftreten, verfälschen diese das Messergebnis und es treten deutliche Messfehler auf.

Es folgt nunmehr die Beschreibung der Besonderheit der vorliegenden Erfindung.

In Figur 2 ist für den Fall einer beispielhaften Netzstörung zum Zeitpunkt t₁ bis zum Zeitpunkt t₂ der zeitliche Verlauf des Messstromes eines Differenzstromwandlers dargestellt. Zu Beginn jeder Schalthandlung im Netz steigt der Messstrom durch die Störung deutlich an und klingt nach einer e-Funktion bis zum Endwert langsam ab. Der Vorgang wiederholt sich auf Grund der Schalthandlung von t₂ bis t₄ in umgekehrter Polarität. Aus diesen zeitlichen Verlauf wird durch Integration des Messstromes das zugehörige Strom-Zeit-Produkt A1 und A2 über die gesamte Störzeit gebildet und gespeichert. Durch anschlie-βende Division des Strom-Zeit-Produktes der erfassten Störung A1 und A2 durch den zur Gewährleistung des Personenschutzes maximal zulässigen Prüfstromes zum Beispiel 1 mA wird die Zeit t₃ bzw. t₅ ermittelt. Die Zeit t1 bis t₅ wird als Prüfimpulszeit t₅ und die Zeit t₅ bis t₆ als Pausenzeit dem Prüfspannungsgenerator als Vorgabewert übermittelt. Bei einer Veränderung der Netzstörungen wird die Prüfimpulszeit selbsttätig entsprechend angepasst. Wird über eine längere parametierbare Zeit keine Netzstörung erfasst, wird die Prüfimpulszeit des Prüfspannungsgenerators schrittweise bis auf minimal 2 Sekunden verringert.

In Figur 3 tritt ein Isolationsfehler zum Zeitpunkt t₀ auf, der durch ein Isolationsüberwachungsgerät signalisiert wird. Im nächsten Nulldurchgang der Netzspannung zum Zeitpunkt t₁ wird dadurch der Prüfspannungsgenerator mit der voreingestellten Prüfimpulszeit timp gestartet. Der Messstrom IMess steigt sprunghaft an und klingt nach einer e-Funktion ab. Durch die Rückkopplung im Messkreis des Differenzstromwandlers wird in den Messkreis eine negative Spannung eingespeist, so dass dadurch die Zeitkonstante TImp entsprechend variabel ist und über die gesamte Prüfimpulszeit einen Messstrom IMess erfasst wird. Nach Ablauf der Prüfimpulszeit zum Zeitpunkt t₅ wird während der Pausenzeit t_{P} bis zum Zeitpunkt t₆ die Prüfspannung abgeschaltet. Dadurch wird zum Zeitpunkt t₅ ein Messstrom mit umgekehrter Polarität erzeugt, der durch Umschalten der Rückkopplung RK in Form eines PI-Reglers zwangsweise und innerhalb kurzer zeit auf Null geschaltet wird. Zum Zeitpunkt t₆ ist ein Messzyklus abgeschlossen und es beginnt ein neuer Messzyklus mit umgekehrter Polarität.

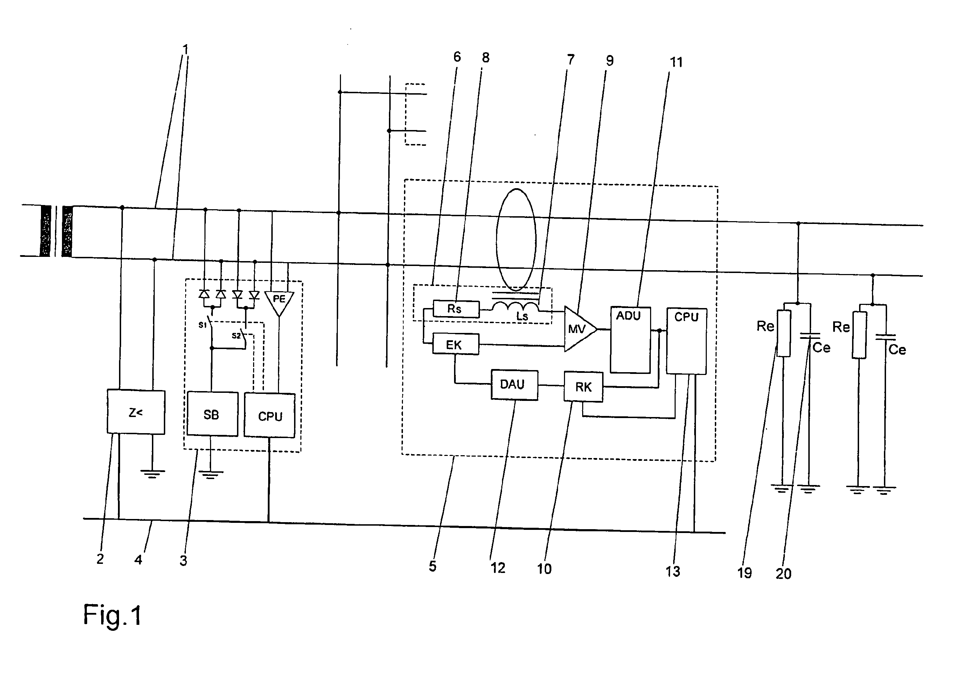

In Fig. 1 ist eine Einrichtung bestehend aus Isolationsüberwachungsgerät 2, Prüfspannungsgenerator 3 und Differenzstromwandler 5 in einem isolierten Netz mit Netzleitern 1 und Isolationswiderstand mit ohmschen Widerstand Rₑ und kapazitiven Widerstand Cₑ dargestellt. Die Geräte sind mittels Busleitung 4 miteinander verbunden. Bereits vor Auftreten eines Isolationsfehlers werden die auftretenden Netzstörungen über die Differenzstromwandler 5 erfasst und entsprechend Fig. 2 die Prüfimpulszeit berechnet und über die Busleitung 4 an den Prüfsignalgenerator 3 übertragen. Über CPU und Schalter s1 und s2 des Prüfspannungsgenerators 3 werden pulsierende Prüfströme variabler Länge und Polarität erzeugt, die über die ohmschen Widerstände Rₑ 19 und den Prüfspannungsgenerator 3 fließen. Die Messung des Prüfstromes für jeden Netzabgang erfolgt durch Differenzstromwandler 5. Zur Erreichung großer Prüfimpulszeiten ist eine schaltbare Rückkopplung RK 10 in den Messkreis des Differenzstromwandlers 5 angeordnet, die während der Prüfimpulszeit eine negative Spannung über die Rückkopplung RK 10 in den Messkreis einspeist und damit die Zeitkonstante des Messstromes IMess bis zu ca. 20 Sekunden erhöht. Während der Pausenzeit wird die Rückkopplung RK als PI-Regler geschaltet und dadurch eine Nullstellung des Messstromes IMess in der Pausenzeit erzwungen.

Es sollen im Folgenden die Funktion des Prüfspannungsgenerators und die Fehlerunterscheidungsmöglichkeiten, die sich daraus ergeben, beschrieben werden.

Um einen Prüfstrom durch den Isolationswiderstand zu treiben, nimmt der Prüfspannungsgenerator 3 eine definierte Erdung des Netzes vor. Diese Erdung geschieht über die in Fig. 1 gezeichnete Strombegrenzung SB. Dieser Zweipol hält den fließenden Prüfstrom unabhängig vom Spannungsabfall über sich selbst konstant. Über ein schaltbares Diodennetzwerk lässt er sich auf unterschiedliche Arten zwischen Netz und Erde schalten, wodurch die Einspeisung unterschiedlicher Prüfspannungsarten in das Netz möglich ist. Je nach Art des vorliegenden Isolationsfehlers kommt es bei den unterschiedlichen Prüfspannungsarten zu Prüfstromflüssen oder nicht. Aus der Auswertung der Prüfstromflüsse bei den verschiedenen Prüfspannungsarten kann auf die Art des Isolationsfehlers geschlossen werden. Es ist dadurch eine Aussage möglich, auf welcher Netzleitung L1, L2 sich ein Isolationsfehler befindet und ob er im Netz selbst oder in einem Gerät hinter einem Netzgleichrichter aufgetreten ist.

### Bezugszeichenliste

- 1: Netzleiter
- 2: Isolatiönsüberwachungsgerät
- 3: Prüfspannungsgenerator
- 4: Busleitung
- 5: Differenzstromwandler
- 6: Differenzstromsensor
- 7: Ersatzinduktivität
- 8: Ersatzwiderstand
- 9: Messverstärker
- 10: Rückkopplung
- 11: Analog Digital Umsetzer
- 12: Digital Analog Umsetzer
- 13: Mikrorechner
- 14:
- 15: Zykluszeit
- 16:
- 17:
- 18: Differenzstrom Messwert
- 19: Ohmscher Widerstand
- 20: Kapazitiver Widerstand
- 21: Netzspannung
- 22: Prüfspannung
- 23:

## Patentansprüche

1. Verfahren zur Ortung von Isolationsfehlern in isolierten ungeerdeten Wechselspannungsnetzen mit Isolationsüberwachungsgerät zur Isolationsüberwachung und netzeigenen Prüfspannungsgenerator, so dass bei Auftreten und Erfassung eines Isolationsfehlers durch das Isolationsüberwachungsgerät durch Schließen des Fehlerstromkreises über Gleichrichter und Strombegrenzung des Prüfspannungsgenerators und über Netzleiter und Erde ein Prüfstrom niedriger Frequenz fließt, der durch Anordnung von Differenzstromwandlern in jeden einzelnen Netzabgang erfasst wird und die Fehlerortung durch Auswertung der Größe des zugehörigen Prüfstromes pro Netzabgang erfolgt **dadurch gekennzeichnet, dass** für jeden Netzabgang im abgeschalteten Zustand des Prüfspannungsgenerators der zeitliche Verlauf von Netzstörungen erfasst wird und über die zugehörige Stromzeitfläche und einem zulässigen Prüfstrom eine minimale Prüfimpulszeit gebildet wird, dass aus dem zeitlichen Verlauf der Netzstörungen die Stromzeitfläche ermittelt und gespeichert wird und eine variable Verknüpfung der Prüfimpulszeit der Prüfspannung mit diesen erfassten Netzstörungen gebildet wird,
dass die Prüfspannung aus pulsierenden netzsynchronen Einzelimpulsen mit einer Dauer zwischen 2 Sekunden und 20 Sekunden besteht, dass nach der Prüfimpulszeit eine Pausenzeit gebildet wird und die Pausenzeit der Prüfimpulszeit entspricht und dass bei Ausbleiben von Netzstörungen die Prüfimpulszeit schrittweise bis auf minimal 2 Sekunden verringert wird.

2. Einrichtung zur Durchführung des Verfahrens nach Anspruch 1 mit an Wechselstromnetz (1) und Erde angeordneten Isolationsüberwachungsgerät (2) und Prüfspannungsgenerator (3), so dass bei Auftreten eines Isolationsfehlers durch das Isolationsüberwachungsgerät durch Schließen des Fehlerstromkreises über Gleichrichter und Strombegrenzung des Prüfspannungsgenerators über Netzleiter und Erde ein Prüfstrom erzeugt wird, der durch Anordnung von Differenzstromwandlern (5) mit Differenzstromsensor (6), bestehend aus Ersatzinduktivität (7) und Ersatzwiderstand (8), in jeden Netzabgang erfasst wird und daraus der Isolationswiderstand jedes Netzabgangs bestimmt wird, **dadurch gekennzeichnet,**
- **dass** der Differenzstromwandler (5) mit Messverstärker (9),Analog Digital Umsetzer (11) und Mikrorechner (13) ausgeführt ist, welcher bei abgeschalteten Prüfspannungsgenerator aus Messstrom durch Störung und Störungszeit die Stromzeitfläche ermittelt und speichert und das Ergebnis aus Division mit mit dem maximal zulässigen Prüfstrom auf die Veränderung der Prüfimpulszeit wirkt - dass im Differenzstromwandler (5) eine schaltbare Rückkopplung zwischen dem Ausgang des Analog Digital Umsetzers (11) und Einkopplung (14) über Digital Analog Umsetzer (12) im Messstromkreis angeordnet ist, die mit Mikrorechner (13) des Differenzstromwandlers (5) schaltbar ist und damit die Messzeitkonstante (Timp) des Messstromes (IMess) während der Prüfimpulszeit variabel verlängert und über Zeitkonstante (TP) während der Pausenzeit den Messstrom auf Null stellt,
- **dass** in dem Mikrorechner (13) des Differenzstromwandler (5) während der Prüfimpulszeit ein Mittelwert über die gesamt Prüfimpulsdauer gebildet wird und dieser Mittelwert ein Maß für den Isolationsfehler pro Netzabgang ist,
- **dass** Isolationsüberwachungsgerät, Mikrorechner (13) im Differenzstromwandler (5) und Mikrorechner (13) im Prüfspannungsgenerator (3) über Busleitung miteinander verbunden sind und darüber die Übertragung von Prüfimpulszeit zum Prüfsignalgenerator erfolgt,
- **dass** der Mikrorechner (13) im Prüfspannungsgenerator (3) mit einem oder mehreren Schaltern (s1,s2..) verbunden ist, sodass damit eine Prüfspannung (22) mit positiver und /oder negativer Polarität und variabler Frequenz und damit unterschiedliche Prüfströme zwischen Netzleitern (1) und Erde schaltbar sind.

## Claims

1. Method for finding the locations of insulation faults in insulated, ungrounded AC power networks with an insulation monitoring device for monitoring the insulation and a test voltage generator built in to the network so that when an insulation fault occurs and is detected by the insulation monitoring device, a low frequency test current flows through the phase conductor and ground by closing the fault circuit using rectifiers and limiting the current of the test voltage generator that is detected by differential current transformers installed in each individual network feeder so that the location of the fault is determined by evaluating the amplitude of the corresponding test current in each network feeder **characterized in that** when the test voltage generator is switched off, the progress over time of power interruptions is detected for each network feeder and a minimum test pulse time is formed from the corresponding current/time area and a permissible test current; that the current/time area is determined from the progress over time of the power interruptions and then stored and forms a variable connection of the test pulse time of the test voltage with the power interruptions detected; that the test voltage consists of individual grid-synchronized pulses with a duration between 2 seconds and 20 seconds; that a pause time is created after the test pulse time where the pause time matches the test pulse time; and that when no power interruptions occur, the test pulse time is reduced step-by-step down to a minimum of 2 seconds.

2. Equipment to execute the method according to Claim 1 with an insulation monitoring device (2) built in to the AC power network (1) and ground and a test voltage generator (3) so that when an insulation fault occurs, a test current is generated by the insulation monitoring device by closing the fault circuit using rectifiers and limiting the current of the test voltage generator through the phase conductor and ground that is detected in each network feeder by an arrangement of differential current transformers (5) with differential current sensors (6) consisting of an equivalent inductance (7) and equivalent resistance (8) and that is used to determine the isolation resistance of each network feeder, **characterized in that**
- the differential current transformer (5) is equipped with a measuring amplifier (9), analog/digital converter (11), and microcomputer (13) that, when the test voltage generator is switched off, stores the current/time area determined from the measuring current caused by the fault and the fault time, the result of which changes the test pulse time through division with the maximum permissible test current,
- in the differential current transformer (5), there is a switchable feedback loop located in the measuring circuit between the output of the analog/digital converter (11) and the connection (14) of the digital/analog converter (12) that can be switched with the microcomputer (13) of the differential current transformer (5) and therefore variably changes the measuring time constant (Timp) of the measuring current (IMeas) during the test pulse time and sets the measuring current to zero during the pause time using the time constant (TP),
- an average value over the entire duration of the test pulse during the test pulse time is formed in the microcomputer (13) of the differential current transformer (5) and that this average value is a measure of the insulation fault on each network feeder,
- the insulation monitoring device, microcomputer (13) in the differential current transformer (5), and microcomputer (13) in the test voltage generator (3) are connected to each other by a bus line and that the test pulse time is transmitted to the test signal generator over this bus line,
- the microcomputer (13) in the test voltage generator (3) is connected to one or more switches (s1, s2,...) so that a test voltage (22) with positive and/or negative polarity and variable frequency, and therefore different test currents, can be switched between phase conductors (1) and ground.

## Revendications

1. Procédé pour localiser les défauts d'isolement dans les réseaux à courant alternatif isolés, non reliés à la terre, avec un appareil de contrôle d'isolement pour contrôler l'isolement et un générateur de tension d'essai, de réseau, de sorte que circule, lors de l'apparition et de la saisie d'un défaut d'isolement par l'appareil de contrôle d'isolement par fermeture du circuit de courant de fuite via un redresseur de courant et une limitation de courant du générateur de tension d'essai et via un conducteur de réseau et la terre, un courant d'essai de basse fréquence, qui est saisit par l'agencement des transformateurs de courant différentiel résiduel dans chaque sortie de réseau individuelle et la localisation du défaut s'effectue par l'évaluation du débit du courant d'essai associé par sortie de réseau **caractérisé par le fait que** pour chaque sortie de réseau, lorsque le générateur de tension d'essai est débranché, la durée des défaillances de réseau est saisie et via la surface temps-courant associée et un courant d'essai admissible, un temps d'impulsion d'essai minimal se produit, de sorte que à partir de la durée des défaillances de réseau la surface temps-courant soit déterminée et mémorisée et une combinaison variable du temps d'impulsion d'essai avec ces défaillances de réseau saisies soit formée, de sorte que la tension d'essai consiste en des impulsions individuelles pulsant de façon synchrone au réseau, d'une durée entre 2 et 20 secondes, de sorte qu'après le temps d'impulsion d'essai il y ait un temps de pause et que le temps de pause corresponde au temps d'impulsion d'essai et que lorsqu'en cas d'absence de défaillances de réseau, le temps d'impulsion d'essai soit réduit progressivement jusqu'à 2 secondes minimum.

2. Dispositif pour réaliser le procédé d'après l'exigence 1 avec un appareil de contrôle d'isolement (2) relié au réseau à courant alternatif (1) et à la terre et au générateur de tension d'essai (3), de sorte que lors de l'apparition d'un défaut d'isolement par l'appareil de contrôle d'isolement par fermeture du circuit de fuite via un redresseur de courant et une limitation de courant du générateur de tension d'essai via un conducteur de réseau et la terre, un courant d'essai soit produit, qui est saisi par l'agencement de transformateurs de courant différentiel résiduel (5) avec capteur de courant différentiel résiduel (6), comprenant une inductance de remplacement (7) et une résistance de remplacement (8), dans chaque sortie de réseau et de là la résistance d'isolement de chaque sortie de réseau est déterminée, donc caractérisé,
- de sorte que le transformateur de courant différentiel résiduel (5) soit réalisé avec amplificateur de mesure (9), convertisseur numérique analogique (11) et microordinateur (13), qui, lorsque le générateur de tension d'essai est débranché, détermine à partir du courant de mesure la surface temps-courant, par la défaillance et le temps de défaillance et le temps de défaillance, la surface temps-courant et mémorise, et le résultat de la division avec le courant d'essai maximum admissible a un effet sur la modification du temps d'impulsion d'essai - de sorte que dans le transformateur de courant différentiel résiduel (5) une rétroaction commutable soit disposée entre la sortie du convertisseur numérique analogique (11) et la liaison (14) par convertisseur analogique numérique (12) dans le circuit de courant de mesure, qui est commutable avec le microordinateur (13) du transformateur de courant différentiel résiduel (5) et donc prolonge de façon variable la constante du temps de mesure (Timp) du courant de mesure (IMess) pendant le temps d'impulsion d'essai et met à zéro le courant de mesure par une constante de temps (TP) pendant le temps de pause,
- de sorte que dans le microordinateur (13) du transformateur de courant différentiel résiduel (5) pendant le temps d'impulsion d'essai, une valeur moyenne soit créée par l'ensemble de la durée d'impulsion d'essai et cette valeur moyenne soit une mesure pour le défaut d'isolement par sortie de réseau,
- de sorte que l'appareil de contrôle d'isolement, le microordinateur (13) dans le transformateur de courant différentiel résiduel (5) et le microordinateur (13) dans le générateur de tension d'essai (3) soient reliés ensemble par la ligne de bus et donc le transfert s'effectue du temps d'impulsion d'essai jusqu'au générateur de signal de contrôle,
- de sorte que le microordinateur (13) dans le générateur de tension d'essai (3) avec un ou plusieurs commutateurs (s1, s2...) soit lié, de sorte qu'une tension d'essai (22) avec une polarité positive et/ou négative et une fréquence variable et donc des courants d'essai différents entre les conducteurs de réseau (1) et la terre soient commutables.
